# FASCICULE DE BREVET EUROPEEN

(11) **EP 3 975 588 B1**
(45) Date de publication et mention de la délivrance du brevet: **12.07.2023**
(21) Numéro de dépôt: 21199065.0
(22) Date de dépôt: 27.09.2021
(51) Int. Cl.: H04R 31/00, B81C 1/00, H04R 19/00

(54) **PROCÉDÉ DE FABRICATION D'UN TRANSDUCTEUR ÉLECTROACOUSTIQUE**
VERFAHREN ZUR HERSTELLUNG EINES ELEKTROAKUSTISCHEN TRANSDUCERS
METHOD FOR MANUFACTURING AN ELECTROACOUSTIC TRANSDUCER

(30) Priorité: 29.09.2020 FR 2009921
(43) Date de publication de la demande: 30.03.2022
(73) Titulaire: Commissariat à l'Energie Atomique et aux Energies Alternatives, 75015 Paris (FR)
(72) Inventeur: JOET, Loïc, 38054 GRENOBLE CEDEX 09 (FR)
(74) Mandataire: Cabinet Camus Lebkiri

(56) Documents cités:
- EP-A1- 2 541 222
- EP-A1- 3 070 963
- EP-A1- 3 557 881

## Description

### DOMAINE TECHNIQUE DE L'INVENTION

Le domaine technique de l'invention est celui des dispositifs de type microsystèmes électromécaniques (MEMS, pour « microelectromechanical systems » en anglais) ou nanosystèmes électromécaniques (NEMS, pour « nanoelectromechanical systems »). L'invention concerne plus particulièrement un procédé de fabrication d'un transducteur électroacoustique comprenant un dispositif de transmission d'un mouvement et d'une force entre deux zones isolées l'une de l'autre de manière étanche. Un tel transducteur électroacoustique peut être employé en tant que microphone ou haut-parleur.

### ARRIERE-PLAN TECHNOLOGIQUE DE L'INVENTION

Les microphones en microélectromécanique ou nanoélectromécanique représentent un marché en pleine expansion, notamment grâce au développement des appareils nomades, tels que les tablettes, téléphones portables intelligents (smartphones) et aux autres objets connectés, dans lesquels ils remplacent peu à peu les microphones à électret.

Les microphones mesurent une variation rapide de la pression atmosphérique, aussi appelée pression acoustique. Ils comportent donc au moins une partie en contact avec l'extérieur.

La plupart des microphones MEMS ou NEMS fabriqués actuellement sont des microphones à détection capacitive. La demande de brevet FR3059659 décrit un exemple de microphone à détection capacitive comprenant un élément mobile, des moyens de détection capacitive et un dispositif de transmission d'un mouvement entre l'élément mobile et les moyens de détection capacitive.

L'élément mobile est capable de récolter la variation de pression. Il peut être formé par un piston rigide comprenant une membrane, aussi appelée couche mince, et une structure de rigidification de la membrane. La membrane forme une séparation entre une cavité ouverte sur l'environnement extérieur et un volume arrière du microphone, aussi appelé volume de référence car il y règne une pression de référence. Ainsi, une face de la membrane est soumise à la pression de référence et une face opposée de la membrane est soumise à la pression atmosphérique (dont on souhaite détecter la variation). L'élément mobile est relié au dispositif de transmission de mouvement dans une première zone du microphone.

Les moyens de détection capacitive permettent de mesurer le déplacement du piston, et donc la variation de pression. Ils sont disposés dans une deuxième zone isolée de la première zone de manière étanche. Ils comprennent une électrode mobile et au moins une électrode fixe disposée en regard de l'électrode mobile. Les électrodes forment les armatures d'un condensateur dont la capacité varie en fonction du déplacement du piston. La deuxième zone est une chambre sous atmosphère contrôlée (typiquement sous vide) pour réduire les phénomènes de frottement visqueux et les bruits associés.

Le dispositif de transmission comprend au moins un premier bras de transmission s'étendant dans la première zone et au moins un deuxième bras de transmission s'étendant dans la deuxième zone. Le piston est couplé à une première extrémité du premier bras de transmission, tandis que l'électrode mobile des moyens de détection capacitive est couplée à une extrémité du deuxième bras de transmission. Les premier et deuxième bras de transmission sont reliés à leur deuxième extrémité par l'intermédiaire d'une articulation pivot. Cette articulation pivot autorise une rotation des bras de transmission par rapport au bâti du microphone et assure simultanément l'étanchéité entre les première et deuxième zones.

La fabrication d'un tel microphone comprend notamment une étape de détourage du piston et une étape de délimitation des bras de transmission, afin de les rendre mobiles par rapport au bâti. Ces étapes sont difficiles à mettre en oeuvre sans percer le piston et créer des fuites d'air importantes entre la cavité soumise à la pression atmosphérique et le volume arrière du microphone (soumis à la pression de référence).

D'autres transducteurs électroacoustiques similaires sont décrits dans les demandes de brevets EP3070963 A1, EP2541222 A1 et EP3557881 A1.

### RESUME DE L'INVENTION

De manière plus générale, il existe un besoin de fabriquer un transducteur électroacoustique tout en limitant les fuites d'air entre les différents volumes du transducteur électroacoustique, le transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission.

Selon un premier aspect de l'invention, on tend à satisfaire ce besoin en prévoyant un procédé de fabrication comprenant les étapes suivantes :
- prévoir un empilement comprenant successivement un substrat, une première couche sacrificielle et une première couche structurelle ;
- former une deuxième couche sacrificielle sur la première couche structurelle, la deuxième couche sacrificielle comprenant des première et deuxième portions disjointes ;
- former une deuxième couche structurelle sur la première couche structurelle et la deuxième couche sacrificielle ;
- graver la deuxième couche structurelle de façon à exposer la première portion de la deuxième couche sacrificielle et à délimiter la structure de rigidification de l'élément mobile, la deuxième portion de la deuxième couche sacrificielle étant encapsulée par la structure de rigidification ;
- graver la première couche structurelle jusqu'à la première couche sacrificielle de façon à délimiter la membrane de l'élément mobile ;
- graver la première portion de la deuxième couche sacrificielle de façon à exposer une première face de la membrane et graver une portion de la première couche sacrificielle, formant ainsi une cavité qui s'étend sous la structure de rigidification ;
- graver le substrat de façon à délimiter le premier bras de transmission et à libérer au moins partiellement l'élément mobile en débouchant sur la cavité, la première couche sacrificielle et la deuxième portion de la deuxième couche sacrificielle servant de couche d'arrêt à la gravure ;
- graver la première couche sacrificielle de façon à exposer une deuxième face opposée de la membrane.

La deuxième portion de la deuxième couche sacrificielle, encapsulée dans la structure de rigidification de la membrane, sert de couche protectrice ou bouclier contre la gravure de la structure de rigidification lors de l'étape de gravure du substrat. Ainsi, la création de fuites d'air (supplémentaires) à travers l'élément mobile ou piston est empêchée.

Grâce à la deuxième portion de la deuxième couche sacrificielle, il est en outre possible de réduire la distance de recouvrement entre le substrat et la structure de rigidification, diminuant ainsi le phénomène d'amortissement (appelé « squeeze-film damping » en anglais) responsable de bruit mécanique.

De préférence, la deuxième portion de la deuxième couche sacrificielle s'étend autour de la membrane de l'élément mobile, sur plus de 80 % de la périphérie de l'élément mobile, et avantageusement tout autour de la membrane de l'élément mobile.

Dans un mode de mise en oeuvre préférentiel du procédé de fabrication, la deuxième couche sacrificielle comprend en outre une troisième portion disjointe des première et deuxième portions, la troisième portion de la deuxième couche sacrificielle est disposée de façon à être encapsulée par une portion restante de la deuxième couche structurelle après l'étape de gravure de la deuxième couche structurelle et la troisième portion de la deuxième couche sacrificielle sert également de couche d'arrêt lors de l'étape de gravure du substrat.

La troisième portion de la deuxième couche sacrificielle est avantageusement située au voisinage d'une intersection entre la position du premier bras de transmission et la périphérie de la structure de rigidification.

Le procédé de fabrication peut comprendre en outre, après l'étape de gravure des première et deuxième couches sacrificielles et avant l'étape de gravure du substrat, les étapes suivantes :
- disposer un capot sur la deuxième couche structurelle, formant ainsi un assemblage ; et
- retourner l'assemblage.

Outre les caractéristiques qui viennent d'être évoquées dans les paragraphes précédents, le procédé de fabrication selon l'invention peut présenter une ou plusieurs caractéristiques complémentaires parmi les suivantes, considérées individuellement ou selon toutes les combinaisons techniquement possibles :
- la première couche structurelle et la deuxième couche structurelle sont gravées simultanément de façon à délimiter la membrane et la structure de rigidification de l'élément mobile ;
- l'empilement est une structure multicouche de type silicium sur isolant (SOI) ;
- le substrat est en silicium, la première couche sacrificielle est en oxyde de silicium et la première couche structurelle est en silicium ;
- la deuxième couche sacrificielle est en oxyde de silicium ;
- la première couche structurelle présente une épaisseur comprise entre 100 nm et 10 µm ;
- la structure de rigidification de l'élément mobile repose au moins en partie sur la membrane ; et
- la structure de rigidification de l'élément mobile est en contact avec la membrane.

Un deuxième aspect de l'invention concerne un transducteur électroacoustique comprenant :
- un bâti ;
- un élément mobile par rapport au bâti, l'élément mobile comprenant une membrane et une structure de rigidification de la membrane ;
- un premier bras de transmission, l'élément mobile étant couplé à une extrémité du premier bras de transmission ;
la membrane étant formée par une première partie d'une première couche structurelle, la structure de rigidification étant formée par une première partie d'une deuxième couche structurelle disposée sur la première couche structurelle et le bâti comprenant un substrat, une deuxième partie de la première couche structurelle et une deuxième partie de la deuxième couche structurelle, et dans lequel le substrat et la structure de rigidification se superposent sur une distance inférieure à 10 µm, ladite distance étant mesurée dans un plan de coupe transversale de la structure de rigidification.

Dans un mode de réalisation préférentiel, le transducteur comprend un dispositif de transmission d'un mouvement et d'une force entre une première zone et une deuxième zone à atmosphère contrôlée, les première et deuxième zones étant isolées l'une de l'autre de manière étanche, le dispositif de transmission comprenant, outre le premier bras de transmission qui s'étend dans la première zone, un deuxième bras de transmission s'étendant dans la deuxième zone.

L'invention et ses différentes applications seront mieux comprises à la lecture de la description qui suit et à l'examen des figures qui l'accompagnent.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
[Fig. 1] représente schématiquement et partiellement un exemple de transducteur électroacoustique comprenant un piston relié à deux premiers bras de transmission ;
[Fig. 2A] à [Fig. 2H] représentent des étapes d'un procédé de fabrication du transducteur électroacoustique selon la figure 1 ;
[Fig. 3] est une vue en perspective du transducteur électroacoustique après l'étape de libération de la membrane du piston représentée par la figure 2H ;
[Fig. 4B], [Fig. 4D], [Fig. 4E] et [Fig. 4G] représentent en vue de coupe transversale des étapes d'un procédé de fabrication de transducteur électroacoustique selon l'invention, remplaçant les étapes des figures 2B, 2D, 2E et 2G ;
[Fig. 5] est une vue partielle en perspective du transducteur électroacoustique, après que l'étape de la figure 4G ait été accomplie ; et
[Fig. 6D] et [Fig. 6G] représentent les étapes des figures 4D et 4G, selon un plan de coupe P représenté la figure 5, ce plan de coupe étant différent de celui des figures 4D et 4G.

Pour plus de clarté, les éléments identiques ou similaires sont repérés par des signes de référence identiques sur l'ensemble des figures.

### DESCRIPTION DETAILLEE

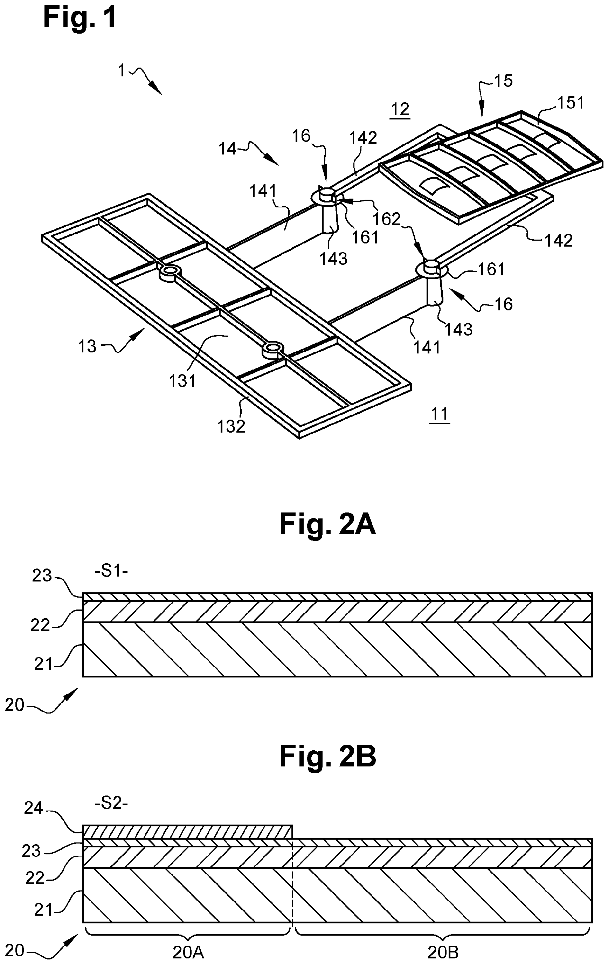

La figure 1 montre un exemple de transducteur électroacoustique 1, de type microphone à détection capacitive, dont on cherche à simplifier la fabrication.

Le transducteur électroacoustique 1 comprend un bâti (non représenté) délimitant au moins en partie une première zone 11 et une deuxième zone 12, un élément mobile 13 par rapport au bâti et un dispositif de transmission 14 d'un mouvement entre la première zone 11 et la deuxième zone 12. Les première et deuxième zones 11-12 du transducteur électroacoustique 1 sont soumises à des pressions différentes. Elles sont isolées l'une de l'autre de manière étanche.

L'élément mobile 13, appelé ci-après piston, est en contact avec la première zone 11. Il comprend une membrane 131 et une structure de rigidification 132 de la membrane, aussi appelée squelette ou armature. La membrane 131 du piston 13 a ici pour rôle de récolter sur toute sa surface une différence de pression entre ses deux faces, pour en déduire une variation de la pression atmosphérique.

La membrane 131 du piston 13 délimite en partie un volume fermé dit de référence, où règne une pression de référence. Elle sépare ce volume de référence d'une cavité ouverte sur l'environnement extérieur, ici l'air. Une face de la membrane 131 est donc soumise à la pression de référence et une face opposée de la membrane 131 est soumise à la pression atmosphérique (dont on souhaite détecter la variation dans le cas d'un microphone).

La première zone 11 peut correspondre à la cavité ouverte sur l'environnement extérieur, et donc être soumise à la pression atmosphérique. Alternativement, la première zone 11 peut être le volume de référence soumis à la pression de référence.

En outre, dans cet exemple particulier, le transducteur électroacoustique 1 comprend des moyens de détection capacitive 15 disposés dans la deuxième zone 12. Ces moyens de détection capacitive 15 permettent de mesurer le déplacement du piston 13, et donc la différence de pression entre ses deux faces. Ils comprennent de préférence une électrode mobile 151 et au moins une électrode fixe disposée en regard de l'électrode mobile 151. Les électrodes forment les armatures d'un condensateur dont la capacité varie en fonction du déplacement du piston 13.

La deuxième zone 12 est une chambre sous atmosphère contrôlée pour réduire les phénomènes de frottement visqueux et les bruits acoustiques associés. Par « chambre sous atmosphère contrôlée », on entend une chambre sous une pression réduite, typiquement inférieure à 10 mbar, et de préférence sous vide.

Le dispositif de transmission 14 est monté mobile en rotation par rapport au bâti, au moyen d'une ou plusieurs articulations pivot 16. Le dispositif de transmission 14 comprend au moins un premier bras de transmission 141 s'étendant dans la première zone 11, au moins un deuxième bras de transmission 142 s'étendant dans la deuxième zone 12 et au moins un arbre de transmission 143 s'étendant en partie dans la première zone 11 et en partie dans la deuxième zone 12. Dans l'exemple de la figure 1, le dispositif de transmission 14 comprend deux premiers bras de transmission 141, deux deuxièmes bras de transmission 142 et deux arbres de transmission 143, chaque arbre de transmission 143 reliant un premier bras de transmission 141 à un deuxième bras de transmission 142.

Chaque premier bras de transmission 141 comprend une première extrémité couplée au piston 13 et une deuxième extrémité opposée, couplée à l'arbre de transmission 143 associé. Chaque deuxième bras de transmission 142 comprend une première extrémité couplée à l'électrode mobile 151 des moyens de détection capacitive 15 et une deuxième extrémité opposée, couplée à l'arbre de transmission 143 associé.

L'arbre de transmission 143 est par exemple en forme de cylindre droit. Les bras de transmission 141-142 ont de préférence la forme d'une poutre de section rectangulaire, avec une dimension (longueur) bien supérieure aux autres (largeur et épaisseur). Le piston 13 a par exemple une forme rectangulaire. Les premiers bras de transmission 141 s'étendent de préférence perpendiculairement à un côté du piston 13, avantageusement un grand côté. Ils peuvent être ancrés à l'intérieur de la périphérie du piston 13, comme cela est représenté par la figure 1, par exemple au moyen d'une première extrémité de forme cylindrique.

Chaque articulation pivot 16 comprend de préférence un élément d'isolation étanche 161, traversé par un arbre de transmission 143, et deux lames 162 alignées, qui s'étendent entre l'arbre de transmission 143 et le bâti. L'élément d'isolation étanche 161 se présente par exemple sous la forme d'une membrane d'étanchéité. Il assure l'étanchéité entre la première zone 11 et la deuxième zone 12 au niveau de l'articulation pivot 16. Les lames 162 sont dimensionnées de sorte à pouvoir se déformer en torsion et permettre la rotation du dispositif de transmission 14. Elles sont de préférence disposées de façon diamétralement opposée par rapport à l'arbre de transmission 143. De préférence, l'élément d'isolation étanche 161 est tel qu'il se déforme également sous l'effet du déplacement en rotation du dispositif de transmission 14.

Le bâti peut notamment comprendre un support (formé par un premier substrat), une couche structurelle (par exemple en silicium) disposée sur le support et un capot rapporté sur la couche structurelle (par exemple formé par un deuxième substrat).

La structure de rigidification 132 de la membrane du piston 13 comprend avantageusement à sa périphérie un rebord qui s'étend dans une direction perpendiculaire à la membrane 131. Ce rebord augmente le chemin de l'air autour du piston et réduit les fuites entre l'environnement extérieur et le volume fermé servant de référence.

Les figures 2A à 2H représentent des étapes S1 à S8 d'un procédé de fabrication du transducteur électrostatique 1. Ces figures montrent de quelle façon le piston 13 peut être formé et désolidarisé du bâti. Seulement une partie du transducteur électrostatique, au voisinage de la périphérie du piston 13, est donc représentée. Dans un souci de simplification, il ne sera fait référence qu'à un seul premier bras de transmission 141, une seule articulation pivot 16, une seule membrane d'étanchéité 161..., étant entendu que tous les éléments d'un même type peuvent être formées simultanément.

[Fig. 2A] La première étape S1 représentée par la figure 2A consiste à fournir un empilement de couches 20 servant de matériau de départ à la réalisation du transducteur. L'empilement 20 comprend successivement un substrat 21, une première couche sacrificielle 22 et une première couche structurelle 23, aussi appelée « couche mince ». La première couche sacrificielle 22 et la première couche structurelle 23 sont disposées sur une face dite principale (aussi appelée face avant) du substrat 21.

Le substrat 21 sert notamment à réaliser le premier bras de transmission 141 et une partie du bâti (le support). Il présente initialement une épaisseur qui peut être comprise entre 500 µm et 700 µm. Le substrat 21 peut être en un matériau semiconducteur, par exemple le silicium.

La première couche structurelle 23 sert à réaliser la membrane 131 du piston 13. Elle peut également servir à réaliser la membrane d'étanchéité 161 de l'articulation pivot 16 et/ou l'électrode mobile 151 des moyens de détection capacitive 15. Elle présente une épaisseur inférieure à celle du substrat 21, de préférence comprise entre 100 nm et 10 µm, par exemple égale à 1 µm. Elle est de préférence constituée du même matériau que le substrat, par exemple le silicium.

La première couche sacrificielle 22 a vocation à disparaître en partie lors de la réalisation du transducteur. Cette couche est notamment utile pour la délimitation du premier bras de transmission 141. Elle peut également servir d'entrefer inférieur dans la zone de détection capacitive du transducteur. Elle peut également permettre de lier mécaniquement le substrat et la première couche structurelle. La première couche sacrificielle 21 peut être constituée d'un matériau diélectrique, de préférence un nitrure de silicium ou un oxyde de silicium, par exemple le dioxyde de silicium (SiO₂). Son épaisseur est par exemple comprise entre 100 nm et 10 µm.

L'empilement 20 peut notamment être une structure multicouche de type silicium sur isolant ou SOI (« Silicon On Insulator » en anglais), communément appelée substrat SOI.

Bien que non représentée par les figures, le procédé de fabrication peut ensuite comprendre une étape de gravure de la première couche structurelle 23. Cette étape de gravure de la première couche structurelle 23 peut notamment servir à former des trous de libération de l'électrode mobile 151 (pour laisser s'infiltrer ultérieurement la solution de gravure de la première couche sacrificielle 22).

[Fig. 2B] A l'étape S2 de la figure 2B, une deuxième couche sacrificielle 24 est formée sur la première couche structurelle 23 dans une première zone 20A de l'empilement 20. Pour ce faire, la deuxième couche sacrificielle 24 peut être d'abord déposée de façon à recouvrir entièrement la première couche structurelle 23 puis gravée partiellement dans une deuxième zone 20B de l'empilement 20, par exemple au travers d'un masque en résine formé par photolithographie. La gravure de la deuxième couche sacrificielle 24 est de préférence sélective par rapport à la première couche structurelle 23. La deuxième couche sacrificielle 24 est avantageusement formée du même matériau diélectrique que la première couche sacrificielle 22, par exemple un oxyde de silicium. Son épaisseur peut être comprise entre 100 nm et 10 µm.

La deuxième couche sacrificielle 24 peut servir d'entrefer supérieur pour la détection capacitive. La gravure de la deuxième couche sacrificielle 24 peut entrainer la gravure de la première couche sacrificielle 22, là où la première couche structurelle 23 a préalablement été gravée (non représenté sur les figures).

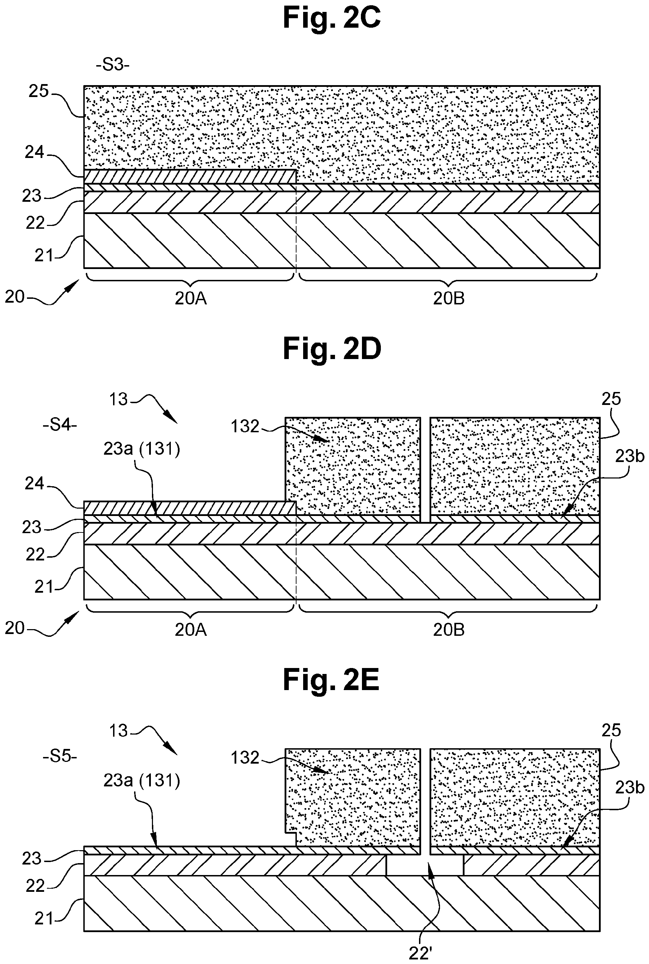

[Fig. 2C] A l'étape S3 de la figure 2C, une deuxième couche structurelle 25 est déposée sur la première couche structurelle 23 (dans la deuxième zone 20B de l'empilement 20) et sur la deuxième couche sacrificielle 24 (dans la première zone 20A de l'empilement 20), par exemple par épitaxie. La deuxième couche structurelle 25 est destinée à former un ou plusieurs éléments (structurels) du transducteur, en particulier la structure de rigidification 132 du piston 13. Elle est avantageusement formée du même matériau que la première couche structurelle 23, par exemple de silicium. L'épaisseur de la deuxième couche structurelle 25 est de préférence comprise entre 5 µm et 50 µm, par exemple égale à 20 µm.

[Fig. 2D] Puis, lors d'une étape S4 représentée par la figure 2D, la deuxième couche structurelle 25 est gravée de façon à délimiter les contours de la structure de rigidification 132 (détourage du piston) et à alléger le piston 13. Dans la première zone 20A de l'empilement 20, la deuxième couche sacrificielle 24 (ex. en oxyde de silicium) sert de couche d'arrêt à la gravure de la deuxième couche structurelle 25 (ex. en silicium), préservant ainsi la première couche structurelle 23 sous-jacente (ex. en silicium). La gravure de la deuxième couche structurelle 25 est donc sélective par rapport à la deuxième couche sacrificielle 24. En revanche, dans la deuxième zone 20B de l'empilement 20, la gravure de la deuxième couche structurelle 25 pour délimiter la périphérie (ou le contour extérieur) de la structure de rigidification 132 débouche sur la première couche structurelle 23. La gravure de la deuxième couche structurelle 25 n'étant pas sélective par rapport à la première couche structurelle 23 (mais uniquement par rapport à la première couche sacrificielle 22), la première couche structurelle 23 est gravée en même temps que la deuxième couche structurelle 25 jusqu'à la première couche sacrificielle 22.

Ainsi, au fond de la tranchée correspondant à la périphérie de la structure de rigidification 132, la première couche structurelle 23 a été gravée et la première couche sacrificielle 22 est exposée.

A l'issue de l'étape S4, la première couche structurelle 23 comprend une première partie 23a et une deuxième partie 23b séparées l'une de l'autre. La première partie 23a de la première couche structurelle 23 (à gauche sur la figure 2D) est destinée à former la membrane 131 du piston 13. Elle est recouverte par la deuxième couche sacrificielle 24 et par une portion désolidarisée de la deuxième couche structurelle 25 formant la structure de rigidification 132 du piston 13.

La technique de gravure employée à l'étape S4 de la figure 2D est avantageusement la gravure ionique réactive profonde (ou DRIE, pour « Deep Reactive Ion Etching » en anglais).

[Fig. 2E] En référence à la figure 2E, le procédé de fabrication comprend ensuite une étape S5 de gravure de la deuxième couche sacrificielle 24 de façon à exposer (partiellement) la première partie 23a de la première couche structurelle 23 (autrement dit de façon à exposer une première face de la membrane 131). Cette étape S5 peut être qualifiée de première étape de libération du piston 13.

La gravure de la deuxième couche sacrificielle 24 est de préférence une gravure isotrope sélective par rapport au substrat 21, à la première couche structurelle 23 et à la deuxième couche structurelle 25. La deuxième couche sacrificielle 24 est de préférence gravée chimiquement, par exemple en plongeant l'empilement dans un bain d'acide fluorhydrique (HF) en phase liquide ou vapeur (dans le cas d'une couche en oxyde de silicium) pendant un temps maîtrisé.

En revanche, une portion de la première couche sacrificielle 22 située à l'aplomb de la périphérie de la structure de rigidification 132 est gravée en même temps que la deuxième couche sacrificielle 24, ce qui forme une cavité 22' dans la première couche sacrificielle 22. La gravure peut être contrôlée en temps de sorte que cette cavité 22' soit peu étendue.

La gravure des couches sacrificielles 22 et 24 peut également servir à libérer l'électrode mobile 151 des moyens de détection capacitive 15 (avant qu'elle ne soit enfermée dans la chambre sous atmosphère contrôlée).

Bien que non représentée par les figures, le procédé de fabrication peut comprendre ensuite une étape de report d'un capot sur la deuxième couche structurelle 25, formant ainsi la chambre sous atmosphère contrôlée, c'est-à-dire la deuxième zone 12. Le capot peut être réalisé par usinage d'un substrat en silicium. Il peut notamment être fixé à la deuxième couche structurelle 25 par collage direct (par exemple Si-Si) ou par scellement eutectique (par exemple Au-Si).

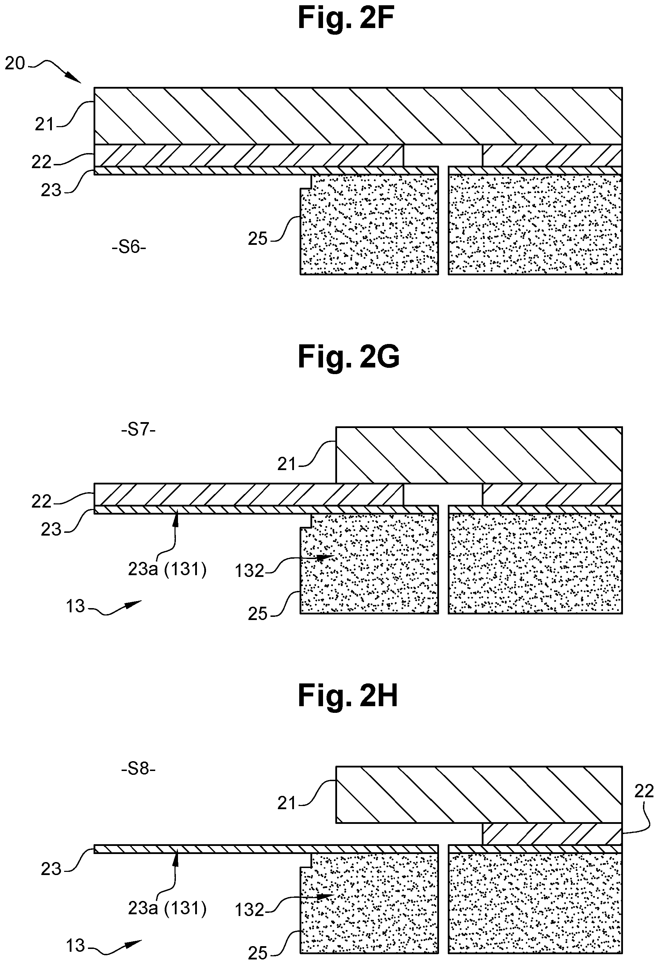

[Fig. 2F] Puis, à l'étape S6 de la figure 2F, l'assemblage formé par l'empilement de couches 20 et le capot (non représenté) est retourné, pour faciliter la gravure ultérieure du substrat 21. Après ce retournement, le substrat 21 est avantageusement aminci, par exemple par gravure DRIE, broyage (« grinding » en anglais) et/ou polissage mécano-chimique (« Chemical mechanical polishing », CMP), de préférence jusqu'à atteindre une épaisseur comprise entre 30 µm à 300 µm, soit l'épaisseur souhaitée pour le premier bras de transmission 141.

[Fig. 2G] L'étape S7 de la figure 2G consiste à graver le substrat 21 (éventuellement aminci) jusqu'à la première couche sacrificielle 22 de façon à créer un accès jusqu'au piston 13 et à délimiter, dans une zone non représentée sur la figure 2G, le premier bras de transmission. La gravure du substrat est de préférence sélective par rapport à la première couche sacrificielle 22. Le substrat 21 peut être gravé par DRIE.

Comme cela est illustré sur la figure 2G, la gravure du substrat 21 pour créer un accès vers la face arrière du piston 13 peut être inscrite à l'intérieur de la périphérie du piston 13, de façon à ne pas déboucher sur la cavité 22' formée à l'étape S5 (cf. Fig. 2E) par la gravure partielle (et involontaire) de la première couche sacrificielle 22. Ainsi, la gravure de l'étape S7 ne s'étend pas au piston 13 comprenant la première partie 23a de la première couche structurelle 23 (membrane 131) et la portion désolidarisée de la deuxième couche structurelle 25 (structure de rigidification 132). A l'intérieur de la périphérie du piston 13, la première couche sacrificielle 22 (ex. en oxyde de silicium) sert de couche d'arrêt à la gravure du substrat 21 (ex. en silicium), préservant ainsi la première partie 23a de la première couche structurelle 23 sous-jacente (ex. en silicium).

Enfin, à l'étape S8 (cf. [Fig. 2H]), la première couche sacrificielle 22 est gravée de façon à découvrir la première partie 23a de la première couche structurelle 23 (autrement dit de façon à exposer une deuxième face opposée de la membrane 131) et la désolidariser du substrat 21. A l'issue de l'étape S8, le piston 13 est libre de se déplacer. L'étape S8 peut donc être qualifiée de deuxième étape de libération du piston 13.

La gravure de la première couche sacrificielle 22 est de préférence une gravure isotrope sélective par rapport au substrat 21, à la première couche structurelle 23 et à la deuxième couche structurelle 25. La première couche sacrificielle 22 est de préférence gravée chimiquement, par exemple en plongeant l'assemblage dans un bain d'acide fluorhydrique (HF) en phase liquide ou vapeur (dans le cas d'une couche en oxyde de silicium) pendant un temps maîtrisé.

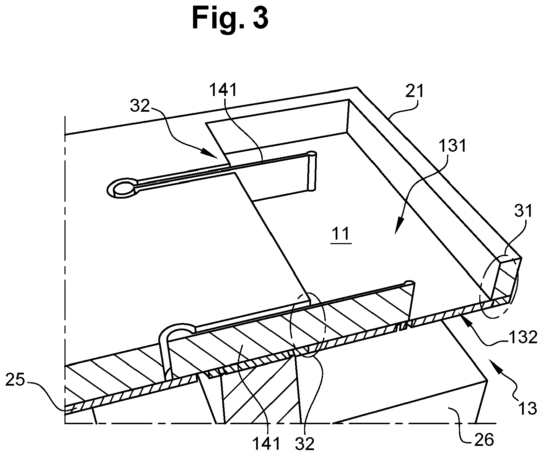

La figure 3 est une vue en perspective de l'assemblage après la deuxième étape de libération du piston S8 (Fig. 2H), coupée selon le plan de symétrie d'un bras de transmission 141. Une partie du capot 26 rapporté sur la deuxième couche structurelle 25 y est représentée.

La première région 31 située à la périphérie de la structure de rigidification 132 est celle représentée en coupe transversale par la figure 2H.

Cette figure montre que la projection verticale (i.e. perpendiculaire au substrat) du premier bras de transmission 141 traverse la périphérie de la structure de rigidification 132 du piston 13. Or à la verticale de cette périphérie se trouve la cavité 22' formée par la gravure de la première couche sacrificielle 22.

Ainsi, dans une deuxième région 32 de l'empilement autour d'une intersection entre la projection (ou la position) du premier bras de transmission 141 et la périphérie de la structure de rigidification 132, la gravure du substrat 21 coïncide avec la gravure (subie) de la première couche sacrificielle 22. La première couche sacrificielle 22 ne peut donc plus servir de couche d'arrêt à la gravure du substrat 21. Cette gravure n'est pas interrompue et s'étend à la première couche structurelle 23 et à la deuxième couche structurelle 25. Un tel phénomène est problématique car il crée des fuites d'air importantes entre la première zone 11 situé d'un côté de la première couche structurelle 23 et le volume situé du côté opposée de la première couche structurelle 23 (ici sous le capot 26). Ce problème de fuites se pose naturellement à chaque premier bras de transmission 141, lorsque le dispositif de transmission en compte plusieurs.

Par ailleurs, lors du déplacement du piston 13, de l'air est pincé entre la structure de rigidification 132 et la portion restante du substrat 21, et ce sur quasiment toute la périphérie du piston 13 (cf. Fig.2H & 3). Ce pincement d'air est dû au fait que la gravure du substrat 21 est inscrite à l'intérieur de la périphérie du piston 13. Il est à l'origine d'un phénomène d'amortissement, appelé « squeeze-film damping » en anglais, qui génère du bruit mécanique et entraîne une diminution des performances du transducteur. La force de ce phénomène d'amortissement est inversement proportionnelle au cube de la distance de recouvrement entre le piston 13 et le bâti (soit ici la portion restante du substrat 21).

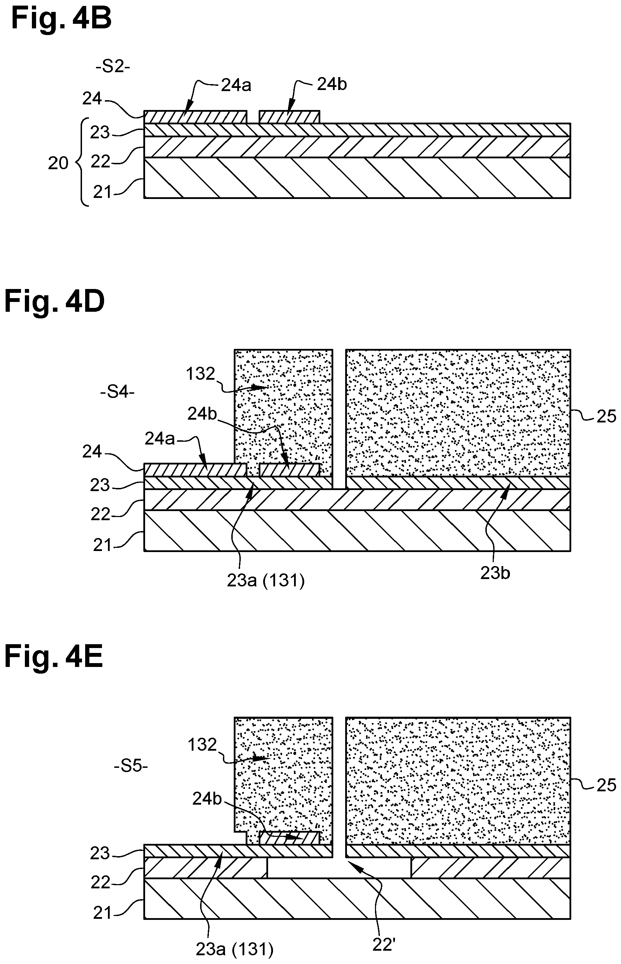

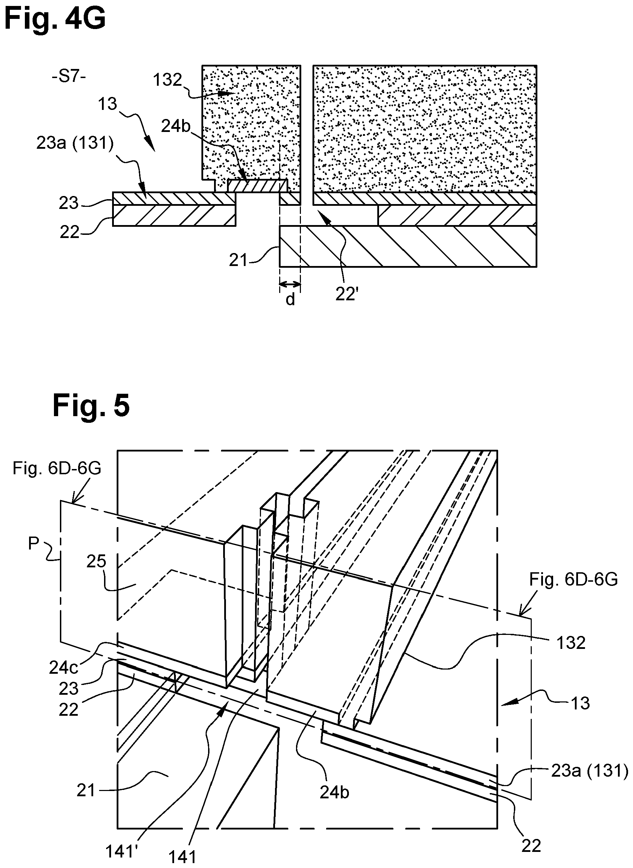

Les figures 4B, 4D, 4E et 4G illustrent en vue de coupe transversale une façon différente d'accomplir les étapes S2, S4, S5 et S7 du procédé de fabrication, afin de limiter les fuites d'air entre la première zone et le volume de référence tout en réduisant le phénomène d'amortissement.

[Fig. 4B] La figure 4B représente l'étape S2 de formation de la deuxième couche sacrificielle 24 sur la première couche structurelle 23 de l'empilement 20. L'étape S2 est ici accomplie de sorte que la deuxième couche sacrificielle 24 comporte une première portion 24a et une deuxième portion 24b distincte de la première portion 24a. Ainsi, par rapport à l'étape S2 de la figure 2B, la deuxième couche sacrificielle 24 comprend (au niveau du piston) deux portions distinctes au lieu d'une seule portion.

La première portion 24a et la deuxième portion 24b de la deuxième couche sacrificielle 24 sont espacées l'une de l'autre, de sorte que la deuxième couche structurelle 25 déposée ultérieurement (et destinée à former la structure de rigidification 132) soit en contact avec la première couche structurelle 23 (destinée à former la membrane 131).

Les première et deuxième portions 24a-24b de la deuxième couche sacrificielle 24 sont de préférence formées par gravure d'une couche diélectrique préalablement déposée sur la première couche structurelle 23, la gravure étant sélective par rapport à la première couche structurelle 23. Le dépôt peut être conforme, de sorte que les première et deuxième portions 24a-24b présentent la même épaisseur. A l'inverse, le dépôt peut être planarisant s'il est suivi par un polissage mécano-chimique.

[Fig. 4D] La figure 4D représente l'étape S4 de gravure de la deuxième couche structurelle 25, après son dépôt sur la première couche structurelle 23 et la deuxième couche sacrificielle 24, par exemple par épitaxie (étape S3 de la figure 2C). La deuxième couche structurelle 25 est gravée de façon à exposer la première portion 24a de la deuxième couche sacrificielle 24 (allégement du piston) et à délimiter la structure de rigidification 132. En outre, la structure de rigidification 132 est dimensionnée de sorte à recouvrir entièrement la deuxième portion 24b de la deuxième couche sacrificielle 24. La deuxième portion 24b de la deuxième couche sacrificielle 24, disposée sur la première couche structurelle 23, se trouve alors encapsulée par la structure de rigidification 132.

Comme décrit précédemment en référence à la figure 2D, la première couche structurelle 23 peut être gravée au cours de la même étape S4 pour délimiter la membrane 131 (tel est généralement le cas lorsque la première couche structurelle 23 et la deuxième couche structurelle 25 sont formées du même matériau). La première couche structurelle 23 est ainsi séparée en deux portions : une première portion 23a formant la membrane 131 du piston et une deuxième portion 23b appartenant au bâti du transducteur.

Une alternative consiste à graver la deuxième couche structurelle 25 et la première couche structurelle 23 séparément, en utilisant des chimies de gravure différentes, lorsque les deux couches sont formées de matériaux différents.

[Fig. 4E] A l'étape S5 de la figure 4E, la deuxième couche sacrificielle 24 est gravée de la façon décrite en référence à la figure 2E (gravure sélective par rapport au substrat 21, à la première couche structurelle 23 et à la deuxième couche structurelle 25), jusqu'à retirer entièrement la première portion 24a. Simultanément, une portion de la première couche sacrificielle 22 est gravée, en partant du fond de la tranchée correspondant à la périphérie de la structure de rigidification 132, formant ainsi la cavité 22'.

Comme la deuxième portion 24b de la deuxième couche sacrificielle 24 est entourée du matériau de la première couche structurelle 23 et du matériau de la deuxième couche structurelle 25, elle n'est pas affectée par la gravure.

La cavité 22' s'étend sous la deuxième portion 24b de la deuxième couche sacrificielle 24, sans toutefois aller au-delà. La gravure est en effet contrôlée en temps de sorte que l'extrémité latérale de la cavité 22' se situe à l'aplomb de la deuxième portion 24b.

[Fig. 4G] La figure 4G représente l'étape S7 de gravure du substrat 21 (éventuellement après report du capot et/ou retournement de l'assemblage ; étape S6 de la figure 2F), permettant d'accéder à la face arrière du piston 13 et de délimiter le premier bras de transmission 141 (cf. Fig.3). Contrairement à la façon décrite en relation avec la figure 2G, le substrat 21 est ici gravé de façon à déboucher dans la cavité 22' formée à l'étape S5 de la figure 4E. Cela a pour conséquence que le piston 13 est désormais libre de se déplacer.

Comme la gravure du substrat 21 est sélective par rapport au matériau de la première couche sacrificielle 22 et au matériau de la deuxième couche sacrificielle 24, la gravure ne se propage ni à la membrane 131, ni à la structure de rigidification 132. En effet, la première couche sacrificielle 22 et la deuxième portion 24b de la deuxième couche sacrificielle 24 servent de couches d'arrêt à la gravure (la deuxième portion 24b de la deuxième couche sacrificielle 24 est révélée par la gravure d'une portion de la première couche structurelle 23, non protégée par la première couche sacrificielle 22).

Ainsi, la deuxième portion 24b de la deuxième couche sacrificielle 24 permet non seulement de limiter les fuites de part et d'autre du piston, en servant de bouclier lors de la gravure du substrat 21, mais également de réduire la distance d sur laquelle le substrat 21 et la structure de rigidification 132 se superposent. Le phénomène de pincement d'air et d'amortissement (« squeeze-film damping ») est alors réduit par rapport à la configuration de la figure 2G. La distance d de recouvrement entre le substrat 21 et la structure de rigidification 132 est mesurée parallèlement à la face principale du substrat 21 dans le plan de coupe transversale de la figure 4G, autrement dit dans le sens de la largeur de la structure de rigidification 132. Elle est avantageusement inférieure à 10 µm, de préférence inférieure à 6 µm. Dans le cas de la figure 2G, la distance de recouvrement est typiquement de 15 µm.

Le substrat 21 est avantageusement gravé de telle façon qu'il se superpose en partie avec la deuxième portion 24b de la deuxième couche sacrificielle 24 après gravure. Ainsi, le bord de la structure de rigidification 132 n'est pas rogné.

Le procédé de fabrication s'achève par l'étape S8 de gravure de la première couche sacrificielle 22, comme décrit en relation avec la figure 2H. La deuxième portion 24b de la deuxième couche sacrificielle 24 peut être gravée simultanément (notamment lorsqu'elle est formée du même matériau).

La figure 5 est une vue partielle en perspective du transducteur électroacoustique après l'étape S7 de gravure du substrat 21. La deuxième couche structurelle 25 a été rendue transparente.

Cette figure montre que la deuxième portion 24b de la deuxième couche sacrificielle 24 est située sous la structure de rigidification 132 et peut s'étendre autour de la membrane 131, sur une grande partie de la périphérie du piston 13, typiquement plus de 80 % de la périphérie du piston 13, et de préférence plus de 90 %. De préférence, la deuxième portion 24b est située tout autour de la membrane 131. En effet, la cavité 22' formée dans la première couche sacrificielle 22 s'étend en suivant la périphérie de la structure de rigidification 132. Il est donc préférable de protéger la structure de rigidification 132 sur tout le pourtour du piston 13, afin de minimiser les fuites.

Lorsque la deuxième portion 24b de la deuxième couche sacrificielle 24 ne s'étend pas tout autour de la membrane (par exemple sur 80 % de la périphérie), la membrane 131 peut être libérée complétement qu'à l'issue de l'étape S8 de gravure de la première couche sacrificielle 22. En effet, une portion de la première couche sacrificielle 22 peut relier la membrane 131 au substrat 21, comme illustré par la figure 2G (la gravure du substrat 21 peut ne pas déboucher sur la cavité 22' dans les 20 % restants de la périphérie).

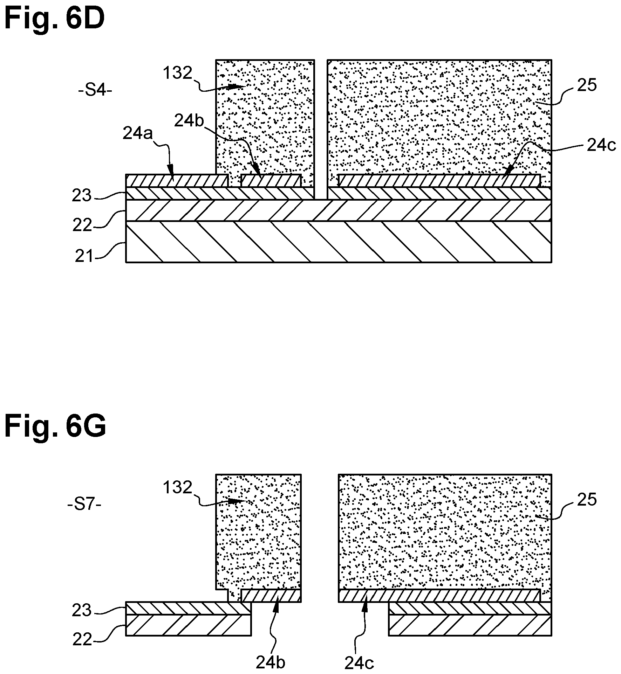

Dans un mode de mise en oeuvre préférentiel du procédé de fabrication, représenté par les figures 5, 6D et 6G, une troisième portion 24c de la deuxième couche sacrificielle 24 est formée à l'étape S2 (en même temps que les première et deuxième portions 24a-24b) et encapsulée entre la première couche structurelle 23 et la partie restante de la deuxième couche structurelle 25 à l'étape S4 (cf. Fig. 6D). Cette troisième portion 24c est distincte des première et deuxième portions 24a-24b et sert à protéger la partie restante de la deuxième couche structurelle 25 (appartenant au bâti) lors de la gravure du substrat 21 (étape S7 ; [Fig. 6G]).

En référence à la figure 5, le substrat 21 est en effet gravé pour délimiter le premier bras de transmission 141. Deux tranchées 141' (ici rectilignes) sont alors formées de part et d'autre du premier bras de transmission 141. Ces tranchées 141' débouchent dans la cavité 22', étant donné qu'elles s'étendent le long du premier bras de transmission 141 et croisent la périphérie de la structure de rigidification 132.

La troisième portion 24c de la deuxième couche sacrificielle 24 est donc encapsulée par la partie restante de la deuxième couche structurelle 25, au voisinage du croisement entre le premier bras de transmission 141 et la périphérie de la structure de rigidification 132 (autrement dit dans la deuxième région 32 de l'empilement, cf. Fig.3), et sert de bouclier à la gravure du substrat 21 uniquement dans cette région. Elle n'a donc pas besoin d'être aussi étendue que la deuxième portion 24b.

Les figures 6D et 6G représentent en coupe le transducteur électroacoustique à l'issue des étapes S4 et S7 respectivement, mais selon un plan de coupe P différent de celui des figures 4D et 4G et visible sur la figure 5. Le plan de coupe P des figures 6D et 6G passe par l'une des tranchées 141' bordant le premier bras de transmission 141 (raison pour laquelle ni le premier bras de transmission 141, ni aucune autre partie de substrat 21, n'apparait pas sur la figure 6G).

Comme cela est représenté sur les figures 5 et 6G, la gravure du substrat 21 entraîne une gravure supplémentaire de la deuxième couche structurelle 25 entre les deuxième et troisième portions 24b-24c de la deuxième couche sacrificielle 24 servant de boucliers. La portion gravée de la deuxième couche structurelle 25 est très peu étendue (quelques micromètres carrés), car la gravure n'a lieu qu'à la verticale des tranchées 141' délimitant le premier bras de transmission 141. Les fuites d'air supplémentaires ne sont donc pas importantes et le comportement du transducteur électroacoustique n'est pas altéré.

Le procédé de fabrication de transducteur électroacoustique selon l'invention a été décrit en prenant pour exemple un microphone à détection capacitive (Fig.1), dont une face est soumise à la pression atmosphérique et l'autre face soumise à une pression de référence. Le procédé de fabrication décrit en relation avec les figures 2A-2H et 4B-4G, est cependant applicable à d'autres types de microphone et à d'autres types de transducteur électroacoustique, notamment un haut-parleur (émetteur sonore) ou un émetteur ultrasonore.

De façon plus générale, un microphone comprend dans la deuxième zone 12 (chambre à atmosphère contrôlée) des moyens de mesure d'un mouvement du dispositif de transmission et/ou d'une force appliquée au dispositif de transmission. Ces moyens de mesure comprennent par exemple une poutre vibrante (microphone à détection résonante).

Dans le cas d'un haut-parleur ou d'un émetteur ultrasonore, un actionneur (par exemple capacitif) remplace les moyens de mesure dans la deuxième zone 22. L'actionneur met en mouvement la première extrémité du deuxième bras de transmission 142. Ce mouvement est transmis par le dispositif de transmission 14 au piston 13 solidaire de la première extrémité du premier bras de transmission 141. Le mouvement de la membrane 131 du piston 13 permet d'émettre un son (ou des ultrasons).

## Revendications

1. Procédé de fabrication d'un transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
procédé comprenant les étapes suivantes :
- prévoir (S1) un empilement (20) comprenant successivement un substrat (21), une première couche sacrificielle (22) et une première couche structurelle (23) ;
- former (S2) une deuxième couche sacrificielle (24) sur la première couche structurelle (23), la deuxième couche sacrificielle (24) comprenant des première et deuxième portions (24a, 24b) disjointes ;
- former (S3) une deuxième couche structurelle (25) sur la première couche structurelle (23) et la deuxième couche sacrificielle (24) ;
- graver (S4) la deuxième couche structurelle (25) de façon à exposer la première portion (24a) de la deuxième couche sacrificielle (24) et à délimiter la structure de rigidification (132) de l'élément mobile (13), la deuxième portion (24b) de la deuxième couche sacrificielle (24) étant encapsulée par la structure de rigidification (132) ;
- graver (S4) la première couche structurelle (23) jusqu'à la première couche sacrificielle (22) de façon à délimiter la membrane (131) de l'élément mobile (13) ;
- graver (S5) la première portion (24a) de la deuxième couche sacrificielle (24) de façon à exposer une première face de la membrane (131) et graver une portion de la première couche sacrificielle (22), formant ainsi une cavité (22') qui s'étend sous la structure de rigidification (132) ;
- graver (S7) le substrat (21) de façon à délimiter le premier bras de transmission (141) et à libérer au moins partiellement l'élément mobile (13) en débouchant sur la cavité (22'), la première couche sacrificielle (22) et la deuxième portion (24b) de la deuxième couche sacrificielle (24) servant de couche d'arrêt à la gravure ;
- graver (S8) la première couche sacrificielle (22) de façon à exposer une deuxième face opposée de la membrane (131).

2. Procédé selon la revendication 1, dans lequel la deuxième portion (24b) de la deuxième couche sacrificielle (24) s'étend autour de la membrane (131) de l'élément mobile (13), sur plus de 80 % de la périphérie de l'élément mobile (13).

3. Procédé selon l'une des revendications 1 et 2, dans lequel la deuxième couche sacrificielle (24) comprend en outre une troisième portion (24c) disjointe des première et deuxième portions (24a, 24b), la troisième portion de la deuxième couche sacrificielle étant disposée de façon à être encapsulée par une portion restante de la deuxième couche structurelle (25) après l'étape de gravure (S4) de la deuxième couche structurelle (25), la troisième portion (24c) de la deuxième couche sacrificielle (24) servant également de couche d'arrêt lors de l'étape (S7) de gravure du substrat (21).

4. Procédé selon la revendication 3, dans lequel la troisième portion (24c) de la deuxième couche sacrificielle (24) est située au voisinage d'une intersection entre la position du premier bras de transmission (141) et la périphérie de la structure de rigidification (132).

5. Procédé selon l'une quelconque des revendications 1 à 4, dans lequel la première couche structurelle (23) et la deuxième couche structurelle (25) sont gravées simultanément de façon à délimiter la membrane (131) et la structure de rigidification (132) de l'élément mobile (13).

6. Procédé selon l'une quelconque des revendications 1 à 5, comprenant en outre, après l'étape (S5) de gravure des première et deuxième couches sacrificielles (22, 24) et avant l'étape (S7) de gravure du substrat (21), les étapes suivantes :
- disposer un capot (26) sur la deuxième couche structurelle (25), formant ainsi un assemblage ; et
- retourner (S6) l'assemblage.

7. Procédé selon l'une quelconque des revendications 1 à 6, dans lequel l'empilement (20) est une structure multicouche de type silicium sur isolant (SOI).

8. Procédé selon l'une quelconque des revendications 1 à 7, dans lequel le substrat (21) est en silicium, la première couche sacrificielle (22) est en oxyde de silicium et la première couche structurelle (23) est en silicium.

9. Procédé selon l'une quelconque des revendications 1 à 8, dans lequel la deuxième couche sacrificielle (24) est en oxyde de silicium.

10. Procédé selon l'une quelconque des revendications 1 à 9, dans lequel la première couche structurelle (23) présente une épaisseur comprise entre 100 nm et 10 µm.

11. Transducteur électroacoustique (1) comprenant :
- un bâti ;
- un élément mobile (13) par rapport au bâti, l'élément mobile (13) comprenant une membrane (131) et une structure de rigidification (132) de la membrane ;
- un premier bras de transmission (141), l'élément mobile (13) étant couplé à une extrémité du premier bras de transmission (141) ;
la membrane (131) étant formée par une première partie (23a) d'une première couche structurelle (23), la structure de rigidification (132) étant formée par une première partie d'une deuxième couche structurelle (25) disposée sur la première couche structurelle (23) et le bâti comprenant un substrat (21), une deuxième partie (23b) de la première couche structurelle (23) et une deuxième partie de la deuxième couche structurelle (25),
transducteur électroacoustique dans lequel le substrat (21) et la structure de rigidification (132) se superposent sur une distance (d) inférieure à 10 µm, ladite distance étant mesurée dans un plan de coupe transversale de la structure de rigidification (132).

12. Transducteur selon la revendication 11, comprenant un dispositif de transmission (14) d'un mouvement et d'une force entre une première zone (11) et une deuxième zone (12) à atmosphère contrôlée, les première et deuxième zones (11, 12) étant isolées l'une de l'autre de manière étanche, le dispositif de transmission (14) comprenant, outre le premier bras de transmission (141) qui s'étend dans la première zone (11), un deuxième bras de transmission (142) s'étendant dans la deuxième zone (12).

## Patentansprüche

1. Fertigungsverfahren für einen elektroakustischen Wandler (1), der umfasst:
- ein Tragelement;
- ein in Bezug zum Tragelement mobiles Element (13), das eine Membran (131) und eine Versteifungsstruktur (132) für die Membran umfasst;
- einen ersten Übertragungsarm (141), wobei das mobile Element (13) mit einem Ende des ersten Übertragungsarms (141) gekoppelt ist;
wobei das Verfahren folgende Schritte umfasst:
- Vorsehen (S1) einer Schichtung (20) von nacheinander einem Substrat (21), einer ersten Opferschicht (22) und einer ersten Strukturschicht (23);
- Bilden (S2) einer zweiten Opferschicht (24) auf der ersten Strukturschicht (23), wobei die zweite Opferschicht (24) erste und zweite, getrennte Abschnitte (24a,24b) umfasst;
- Bilden (S3) einer zweiten Strukturschicht (25) auf der ersten Strukturschicht (23) und der zweiten Opferschicht (24);
- Gravieren (S4) der zweiten Strukturschicht (25) derart, dass der erste Abschnitt (24a) der zweiten Opferschicht (24) exponiert wird und dass die Versteifungsstruktur (132) vom mobilen Element (13) abgegrenzt wird, wobei der zweite Abschnitt (24b) der zweiten Opferschicht (24) durch die Versteifungsstruktur (132) eingekapselt wird;
- Gravieren (S4) der ersten Strukturschicht (23) bis zur ersten Opferschicht (22), sodass die Membran (131) vom mobilen Element (13) abgegrenzt wird;
- Gravieren (S5) des ersten Abschnitts (24a) der zweiten Opferschicht (24), sodass eine erste Seite der Membran (131) exponiert wird und Gravieren eines Abschnitts der ersten Opferschicht (22), sodass auf diese Weise ein Hohlraum (22') entsteht, der sich unter der Versteifungsstruktur (132) erstreckt;
- Gravieren (S7) des Substrats (21), sodass der erste Übertragungsarm (141) abgegrenzt und das mobile Element (13) durch Einmünden in den Hohlraum (22') zumindest teilweise freigesetzt wird, wobei die erste Opferschicht (22) und der zweite Abschnitt (24b) der zweiten Opferschicht (24) als Stoppschicht für die Gravur dienen;
- Gravieren (S8) der ersten Opferschicht (22), sodass eine zweite gegenüberliegende Seite der Membran (131) exponiert wird.

2. Verfahren nach Anspruch 1, bei dem sich der zweite Abschnitt (24b) der zweiten Opferschicht (24) um die Membran (131) des mobilen Elements (13), und zwar auf über 80% des Rands des mobilen Elements (13) erstreckt.

3. Verfahren nach einem der Ansprüche 1 und 2, bei dem die zweite Opferschicht (24) zudem einen dritten, vom ersten und zweiten Abschnitt (24a,24b) getrennten Abschnitt (24c) umfasst, wobei der dritte Abschnitt der zweiten Opferschicht derart angeordnet ist, dass er durch einen nach dem Gravier-Schritt (S4) der zweiten Strukturschicht (25) verbleibenden Abschnitt der zweiten Strukturschicht (25) eingekapselt wird, wobei der dritte Abschnitt (24c) der zweiten Opferschicht (24) auch als Stoppschicht bei dem Gravier-Schritt (S7) des Substrats (21) dient.

4. Verfahren nach Anspruch 3, bei dem sich der dritte Abschnitt (24c) der zweiten Opferschicht (24) in der Nähe einer Schnittstelle zwischen der Position des ersten Übertragungsarms (141) und des Rands der Versteifungsstruktur (132) befindet.

5. Verfahren nach einem der Ansprüche 1 bis 4, bei dem die erste Strukturschicht (23) und die zweite Strukturschicht (25) gleichzeitig graviert werden, sodass die Membran (131) und die Versteifungsstruktur (132) vom mobilen Element (13) abgegrenzt werden.

6. Verfahren nach einem der Ansprüche 1 bis 5, das zudem nach dem Gravier-Schritt (S5) der ersten und zweiten Opferschicht (22,24) und vor dem Gravier-Schritt (S7) des Substrats (21) folgende Schritte umfasst:
- Anordnen einer Verkleidung (26) auf der zweiten Strukturschicht (25), was dadurch eine Verbindung bildet; und
- Umdrehen (S6) der Verbindung.

7. Verfahren nach einem der vorausgehenden Ansprüche 1 bis 6, bei dem die Schichtung (20) eine Mehrschichten-Struktur vom Typ Silizium auf einem Isolierstoff (SOI) ist.

8. Verfahren nach einem der Ansprüche 1 bis 7, bei dem das Substrat (21) aus Silizium ist, wobei die erste Opferschicht (22) aus Siliziumoxid und die erste Strukturschicht (23) aus Silizium ist.

9. Verfahren nach einem der Ansprüche 1 bis 8, bei dem die zweite Opferschicht (24) aus Siliziumoxid ist.

10. Verfahren nach einem der Ansprüche 1 bis 9, bei dem die erste Strukturschicht (23) eine Dicke zwischen 100 nm und 10 µm aufweist.

11. Elektroakustischer Wandler (1), der umfasst:
- ein Tragelement;
- ein in Bezug zum Tragelement mobiles Element (13), das eine Membran (131) und eine Versteifungsstruktur (132) für die Membran umfasst;
- einen ersten Übertragungsarm (141), wobei das mobile Element (13) mit einem Ende des ersten Übertragungsarm (141) gekoppelt ist;
wobei die Membran (131) durch einen ersten Teil (23a) einer ersten Strukturschicht (23) gebildet wird, wobei die Versteifungsstruktur (132) durch einen auf der ersten Strukturschicht (23) angeordneten ersten Teil einer zweiten Strukturschicht (25) gebildet wird, und das Tragelement ein Substrat (21), einen zweiten Teil (23b) der ersten Strukturschicht (23) und einen zweiten Teil der zweiten Strukturschicht (25) umfasst,
elektroakustischer Wandler, bei dem sich das Substrat (21) und die Versteifungsstruktur (132) auf einer Länge (d) von weniger als 10 µm überlappen, wobei diese Länge in einer zur Versteifungsstruktur (132) quer verlaufenden Schnittebene gemessen wird.

12. Wandler nach Anspruch 11, umfassend eine Übertragungsvorrichtung (14) einer Bewegung und einer Kraft zwischen einer ersten Zone (11) und einer zweiten Zone (12) unter kontrollierter Atmosphäre, wobei die erste und zweite Zone (11, 12) undurchlässig zueinander isoliert sind, und wobei die Übertragungsvorrichtung (14) neben dem ersten Übertragungsarm (141), der sich in der ersten Zone (11) erstreckt, einen zweiten Übertragungsarm (142) umfasst, der sich in der zweiten Zone (12) erstreckt.

## Claims

1. Method for manufacturing an electroacoustic transducer (1) comprising:
- a frame;
- an element (13) moveable with respect to the frame, the moveable element (13) comprising a membrane (131) and a structure (132) for rigidifying the membrane;
- a first transmission arm (141), the moveable element (13) being coupled to an end of the first transmission arm (141);
method comprising the following steps:
- providing (S1) a stack (20) successively comprising a substrate (21), a first sacrificial layer (22) and a first structural layer (23);
- forming (S2) a second sacrificial layer (24) on the first structural layer (23), the second sacrificial layer (24) comprising disjointed first and second portions (24a, 24b);
- forming (S3) a second structural layer (25) on the first structural layer (23) and the second sacrificial layer (24);
- etching (S4) the second structural layer (25) so as to expose the first portion (24a) of the second sacrificial layer (24) and to delimit the rigidification structure (132) of the moveable element (13), the second portion (24b) of the second sacrificial layer (24) being encapsulated by the rigidification structure (132);
- etching (S4) the first structural layer (23) to the first sacrificial layer (22) so as to delimit the membrane (131) of the moveable element (13);
- etching (S5) the first portion (24a) of the second sacrificial layer (24) so as to expose a first face of the membrane (131) and to etch a portion of the first sacrificial layer (22), thereby forming a cavity (22') which extends under the rigidification structure (132);
- etching (S7) the substrate (21) so as to delimit the first transmission arm (141) and to release at least partially the moveable element (13) while opening into the cavity (22'), the first sacrificial layer (22) and the second portion (24b) of the second sacrificial layer (24) serving as stop layer to the etching;
- etching (S8) the first sacrificial layer (22) so as to expose a second opposite face of the membrane (131).

2. Method according to claim 1, wherein the second portion (24b) of the second sacrificial layer (24) extends around the membrane (131) of the moveable element (13), over more than 80 % of the periphery of the moveable element (13).

3. Method according to one of claims 1 and 2, wherein the second sacrificial layer (24) further comprises a third portion (24c) disjointed from the first and second portions (24a, 24b), the third portion of the second sacrificial layer being arranged so as to be encapsulated by a remaining portion of the second structural layer (25) after the step of etching (S4) the second structural layer (25), the third portion (24c) of the second sacrificial layer (24) also serving as stop layer during the step (S7) of etching the substrate (21).

4. Method according to claim 3, wherein the third portion (24c) of the second sacrificial layer (24) is situated in the vicinity of an intersection between the position of the first transmission arm (141) and the periphery of the rigidification structure (132).

5. Method according to any one of claims 1 to 4, wherein the first structural layer (23) and the second structural layer (25) are etched simultaneously so as to delimit the membrane (131) and the rigidification structure (132) of the moveable element (13).

6. Method according to any one of claims 1 to 5, further comprising, after the step (S5) of etching the first and second sacrificial layers (22, 24) and before the step (S7) of etching the substrate (21), the following steps:
- arranging a cover (26) on the second structural layer (25), thereby forming an assembly; and
- turning over (S6) the assembly.

7. Method according to any one of claims 1 to 6, wherein the stack (20) is a multilayer structure of silicon on insulator (SOI) type.

8. Method according to any one of claims 1 to 7, wherein the substrate (21) is made of silicon, the first sacrificial layer (22) is made of silicon oxide and the first structural layer (23) is made of silicon.

9. Method according to any one of claims 1 to 8, wherein the second sacrificial layer (24) is made of silicon oxide.

10. Method according to any one of claims 1 to 9, wherein the first structural layer (23) has a thickness comprised between 100 nm and 10 µm.

11. Electroacoustic transducer (1) comprising:
- a frame;
- an element (13) moveable with respect to the frame, the moveable element (13) comprising a membrane (131) and a structure (132) for rigidifying the membrane;
- a first transmission arm (141), the moveable element (13) being coupled to an end of the first transmission arm (141);
the membrane (131) being formed by a first portion (23a) of a first structural layer (23), the rigidification structure (132) being formed by a portion part of a second structural layer (25) arranged on the first structural layer (23) and the frame comprising a substrate (21), a second portion (23b) of the first structural layer (23) and a second portion of the second structural layer (25),
electroacoustic transducer wherein the substrate (21) and the rigidification structure (132) are superimposed over a distance (d) less than 10 µm, said distance being measured in a transversal sectional plane of the rigidification structure (132).

12. Transducer according to claim 11, comprising a device (14) for transmitting a movement and a force between a first zone (11) and a second zone (12) with a controlled atmosphere, the first and second zones (11, 12) being isolated from each other in a sealed manner, the transmitting device (14) comprising, apart from the first transmission arm (141) which extends into the first zone (11), a second transmission arm (142) extending into the second zone (12).
